# EUROPEAN PATENT SPECIFICATION

(11) **EP 3 016 484 B1**
(45) Date of publication and mention of the grant of the patent: **04.08.2021**
(21) Application number: 15192308.3
(22) Date of filing: 30.10.2015
(51) Int. Cl.: H05K 1/02, H01L 23/498, H05K 1/18, H01L 23/00

(54) **SOLID STATE CONTACTOR WITH IMPROVED INTERCONNECT STRUCTURE**
FESTKÖRPERSCHÜTZ MIT VERBESSERTER VERBINDUNGSSTRUKTUR
CONTACTEUR À L'ÉTAT SOLIDE PRÉSENTANT UNE STRUCTURE D'INTERCONNEXION AMÉLIORÉE

(30) Priority: 31.10.2014 US 201414529192
(43) Date of publication of application: 04.05.2016
(73) Proprietor: Goodrich Corporation, Charlotte, NC 28217-4578 (US)
(72) Inventor: PAL, Debabrata, Hoffman Estates, IL Illinois 60195 (US)
(74) Representative: Dehns

(56) References cited:
- US-A- 5 426 263
- US-A1- 2003 137 813
- US-A1- 2004 119 148
- US-B2- 6 946 740
- None

## Description

### BACKGROUND OF THE INVENTION

This application relates to an improved printed wiring board for communicating a power supply to a use.

The control of electronic components is becoming increasingly sophisticated. One common application is a printed wiring board which includes a power supply communicating power through an input bus. A plurality of switches, typically transistors, and in many cases, metal oxide semiconductor field-effect transistors (MOSFETs) communicate the input bus to an output bus. A control board controls operation of a plurality of MOSFETs to selectively transmit power from a power source to various uses.

There are a plurality of such boards utilized on most aircraft, and also in other aerospace applications.

In the known art, the input bus and the output bus have been positioned in a common plane. The MOSFETs are mounted on one of the buses, and connected to the other by wires. This has required a relatively large amount of space between fingers on the input and output buses, and has thus resulted in the overall arrangement being undesirably large.

US 6,946,740 relates to a high power MCM package. US 2003/0137813 relates to a circuit-constituting unit forming a distribution circuit. US 2004/0119148 relates to a semiconductor device package.

### SUMMARY OF THE INVENTION

A printed circuit board for selectively communicating power from a power source to a use according to the present invention is defined in claim 1. The printed circuit board has an input bus for receiving a power supply. A transistor is connected to the input bus and is positioned on one side of the input bus in a first direction. An output bus is connected to the transistor on an opposed side of the transistor relative to the input bus. The transistor is intermediate at the first input and output buses in the first dimension. A power supply system is also disclosed.

These and other features may be best understood from the following drawings and specification.

### BRIEF DESCRIPTION OF THE DRAWINGS

Figure 1 is a side view of a power supply system.
Figure 2 is a top view of the system.

### DETAILED DESCRIPTION

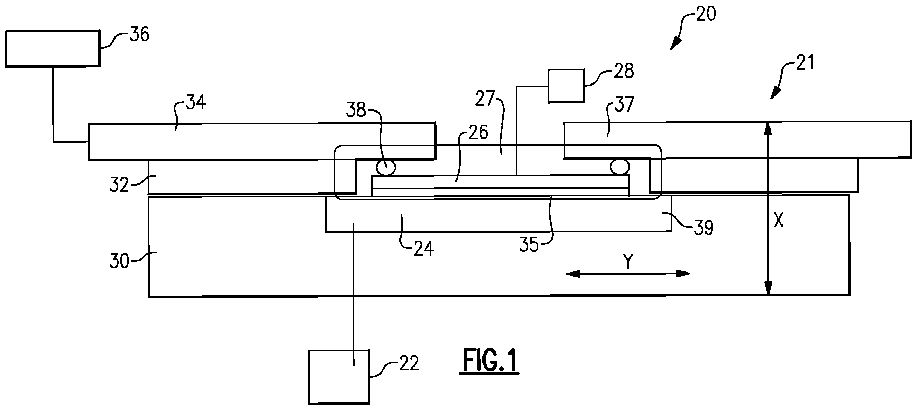

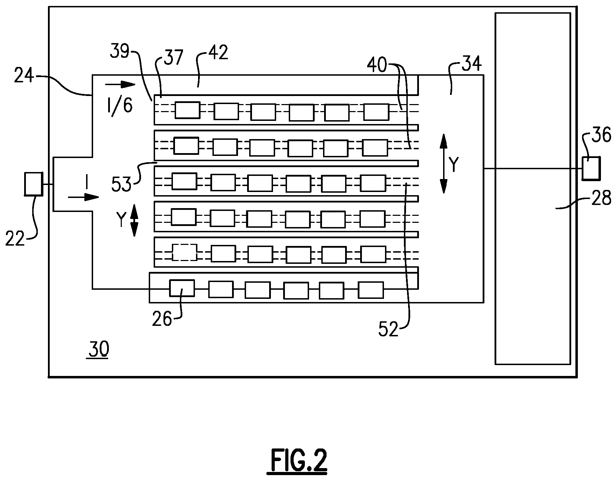

Figure 1 shows a power supply system 20 incorporating a printed wiring board 21. A power supply 22 selectively provides power to an input bus 24. It should be noted that Figure 1 shows only one portion of the wiring board 21, and the wiring board 21 would actually have a plurality of the structure shown in Figure 1, and as perhaps better shown in Figure 2. The input bus 24 is connected to a transistor 26 which may be a MOSFET. An encapsulant 27 encloses the area around the MOSFET 26. A controller 28 controls the transistor 26. A body 30 mounts all of the structure.

It should be understood that control circuitry 28 (See Fig. 2) is incorporated somewhere within the body 30. A spacer 32 may be formed of A1N or Al₂O₃ or other appropriate materials. Spacer 32 separates an output bus 34 from the body 30. A die attachment 35 may connect the transistor 26 to the input bus 24. The output bus 34 communicates with a use 36, which may be a use on an aerospace application.

In fact, the overall system such as shown in Figure 2 may have a plurality of transistors (or MOSFETs) 26, and could communicate with a plurality of uses.

The operation of the control circuit and when it would be desirable to transfer power is known in the art. It is the architecture of the printed wiring board 21 which is novel to this disclosure.

As can be appreciated, the printed wiring board 21 extends along a dimension X and along a dimension Y in the illustrated plane. In the prior art, the buses 24 and 34 would be co-planer in the dimension X. In the prior art, MOSFETs are electrically connected to the bus bars by wire-bonds. However, as can be seen, they are spaced within the X plane in this disclosure. They also overlap within the dimension Y, which is perpendicular to the dimension X. That is, a portion 37 of the output bus 34 is positioned on an opposed side of a solder joint 38 connecting the transistor 26 to the bus 34 relative to the input bus 24. The transistor 26 is, thus, also positioned intermediate the portions 37 and a portion 39 of the input bus 24 on an opposed side of the solder joint 38 and transistor 26. For each MOSFET connection to the bus bar, there will be multiple solder joints 38 such as greater than two and as many as eight or more.

Figure 2 is a view generally looking downwardly on Figure 1. It should be understood that Figure 1 only illustrates a portion of Figure 2. As can be seen, input bus 24 actually has a plurality of fingers 42 which are interspersed with fingers 40 from the output bus 34. The portions 39 and 37 overlap in the Y dimension. Spaces 52 exist between fingers 42 and beneath finger 40. Similar spaces 53 between fingers 40 are above a finger 42. That is, fingers 40/42 span spaces 52/53. With this arrangement, the density of components within the printed circuit board 21 is increased and the overall size can be decreased.

The disclosure could be summarized as describing a printed circuit board 21 that selectively communicates power from a power source 22 to a use 36. An input bus 24 receives the power supply from source 22. A transistor 26 is connected to input bus 24 and positioned on one side of the input bus in a first direction. An output bus 34 is connected to transistor 26 on an opposed side of the transistor 26 relative to input bus 24. Thus, transistor 26 is intermediate the input and output buses in the first dimension. Due to direct solder interconnect, spacing between the bus bars can be reduced. This results in reduction of bus bar width for a given current. Due to direct solder interconnect, more bus bars can be packaged. This reduces heat load. This improves thermal design. For example, current flow per bus bar can be reduced by 33% compared to a prior art printed wiring board.

Although an embodiment of this invention has been disclosed, a worker of ordinary skill in this art would recognize that certain modifications are possible. The following claims determine the scope of protection.

## Claims

1. A printed circuit board (21) for selectively communicating power from a power source (22) to a use (36) comprising:
an input bus (24) for receiving a power supply (22);
a transistor (26) connected to said input bus (24) and positioned on one side of said input bus (24) in a first direction (X) perpendicular to the plane of the printed circuit board;
an output bus (34) connected to said transistor (26) on an opposed side of said transistor (26) relative to said input bus (24), such that said transistor (26) is intermediate said input and output buses (24, 34) in said first direction; and
wherein a die attachment (35) is utilized to connect said transistor (26) to one of said input and output buses (24, 34) and a solder joint (38) is utilized to connect the transistor (26) to the other;
**characterised in that** each of said input and output buses (24, 34) include a plurality of fingers (40, 42), wherein fingers (42) of the input bus (24) are interspersed with fingers (40) from the output bus (34), said fingers (40, 42) having portions (37) overlapping each other in said first direction (X) and other portions (39) which overlap a space (52, 53) between the fingers (40, 42) of the other of said input and output buses (24, 34).

2. The printed circuit board (21) as set forth in claim 1, wherein said transistor (26) is a MOSFET.

3. The printed circuit board (21) as set forth in any preceding claim, wherein a spacer (32) is positioned between said output bus (34) and said circuit board (21).

4. A power supply system (20) comprising:
a source of power (22); and
a printed circuit board (21) as recited in any preceding claim.

5. The power supply (20) system as set forth in claim 4, wherein said use (36) is in an aerospace application.

## Patentansprüche

1. Gedruckte Leiterplatte (21) zum selektiven Leiten von Strom von einer Stromquelle (22) zu einem Verbraucher (36), umfassend:
einen Eingangsbus (24) zum Aufnehmen einer Stromzufuhr (22) ;
einen Transistor (26), der mit dem Eingangsbus (24) verbunden ist und an einer Seite des Eingangsbusses (24) in einer ersten Richtung (X) senkrecht zur Ebene der gedruckten Leiterplatte angeordnet ist;
einen Ausgangsbus (34), der mit dem Transistor (26) an einer gegenüberliegenden Seite des Transistors (26) relativ zum Eingangsbus (24) verbunden ist, so dass der Transistor (26) zwischen dem Eingangs- und dem Ausgangsbus (24, 34) in der ersten Richtung liegt; und
wobei eine Chipbefestigung (35) verwendet wird, um den Transistor (26) mit einem aus dem Eingangs- und dem Ausgangsbus (24, 34) zu befestigen, und eine Lötverbindung (38) verwendet wird, um den Transistor (26) mit dem anderen zu verbinden;
**dadurch gekennzeichnet, dass**
jeder aus dem Eingangs- und dem Ausgangsbus (24, 34) eine Vielzahl von Fingern (40, 42) beinhaltet, wobei Finger (42) des Eingangsbusses (24) mit Fingern (40) vom Ausgangsbus (34) durchsetzt sind, wobei die Finger (40, 42) Abschnitte (37) aufweisen, die einander in der ersten Richtung (X) überlappen, und andere Abschnitte (39) aufweisen, die einen Raum (52, 53) zwischen den Fingern (40, 42) des anderen aus dem Eingangs- und dem Ausgangsbus (24, 34) überlappen.

2. Gedruckte Leiterplatte (21) nach Anspruch 1, wobei der Transistor (26) ein MOSFET ist.

3. Gedruckte Leiterplatte (21) nach einem der vorstehenden Ansprüche, wobei ein Abstandshalter (32) zwischen dem Ausgangsbus (34) und der Leiterplatte (21) angeordnet ist.

4. Stromversorgungssystem (20), Folgendes umfassend:
eine Stromquelle (22); und
eine gedruckte Leiterplatte (21) nach einem der vorstehenden Ansprüche.

5. Stromversorgungs-(20) system nach Anspruch 4, wobei sich der Verbraucher (36) in einer Luftfahrtanwendung befindet.

## Revendications

1. Carte de circuit imprimé (21) pour communiquer sélectivement de l'énergie depuis une source d'énergie (22) vers une utilisation (36) comprenant :
un bus d'entrée (24) pour recevoir une alimentation électrique (22) ;
un transistor (26) relié audit bus d'entrée (24) et positionné sur un côté dudit bus d'entrée (24) dans une première direction (X) perpendiculaire au plan de la carte de circuit imprimé ;
un bus de sortie (34) relié audit transistor (26) sur un côté opposé dudit transistor (26) par rapport audit bus d'entrée (24), de sorte que ledit transistor (26) est intermédiaire entre lesdits bus d'entrée et de sortie (24, 34) dans ladite première direction ; et
dans laquelle une fixation de puce (35) est utilisée pour relier ledit transistor (26) à l'un desdits bus d'entrée et de sortie (24, 34) et un point de soudure (38) est utilisé pour relier le transistor (26) à l'autre ;
**caractérisée en ce que**
chacun desdits bus d'entrée et de sortie (24, 34) comportent une pluralité de doigts (40, 42), dans laquelle les doigts (42) du bus d'entrée (24) sont entrecoupés de doigts (40) depuis le bus de sortie (34), lesdits doigts (40, 42) ayant des parties (37) se chevauchant dans ladite première direction (X) et d'autres parties (39) qui chevauchent un espace (52, 53) entre les doigts (40, 42) de l'autre desdits bus d'entrée et de sortie (24, 34).

2. Carte de circuit imprimé (21) selon la revendication 1, dans laquelle ledit transistor (26) est un MOSFET.

3. Carte de circuit imprimé (21) selon une quelconque revendication précédente, dans laquelle une entretoise (32) est positionnée entre ledit bus de sortie (34) et ladite carte de circuit (21).

4. Système d'alimentation électrique (20) comprenant :
une source d'énergie (22) ; et
une carte de circuit imprimé (21) selon une quelconque revendication précédente.

5. Système d'alimentation électrique (20) selon la revendication 4, dans lequel ladite utilisation (36) est réalisée dans une application aérospatiale.
